# EUROPEAN PATENT APPLICATION

(11) **EP 3 073 397 A2**
(43) Date of publication of application: **28.09.2016**
(21) Application number: 16160583.7
(22) Date of filing: 16.03.2016
(51) Int. Cl.: G06F 17/50

(54) **A METHOD OF MODELLING AT LEAST A PART OF A GAS TURBINE ENGINE**

(30) Priority: 24.03.2015 GB 201504919
(71) Applicant: Rolls-Royce plc, London SW1E 6AT (GB)
(72) Inventor: Di Mare, Luca, Derby, Derbyshire DE24 8BJ (GB); Kulkarni, Davendu Y, Derby, Derbyshire DE24 8BJ (GB); Lu, Gan, Derby, Derbyshire DE24 8BJ (GB)
(74) Representative: Rolls-Royce plc

(57) **Abstract**

A method of modelling at least a part of a gas turbine engine, the method comprising: preparing a model of at least a part of the gas turbine engine using a data structure including: a first set of data entities representing geometrical shapes of physical features; and a second set of data entities representing geometrical shapes of aerodynamic boundaries, the second set of data entities being used to preserve aerodynamic design intent during preparation of the model.

## Description

The present disclosure concerns a method of modelling at least a part of a gas turbine engine.

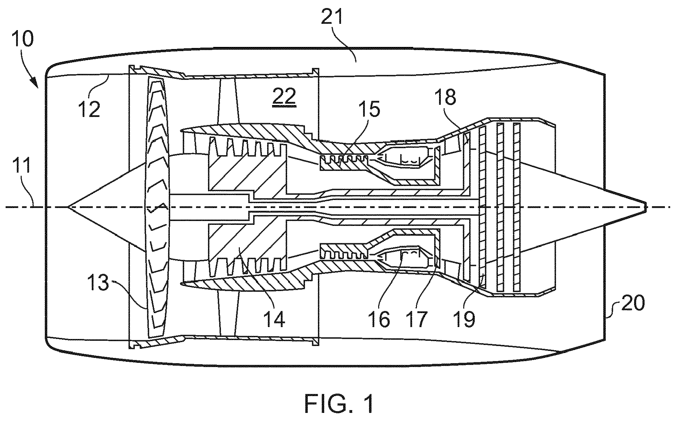

Gas turbine engines may be used to power various systems. For example, gas turbine engines may be used to power aircraft, ships and electrical generators. Fig. 1 illustrates a gas turbine engine 10 for an aircraft according to an example. The gas turbine engine 10 has a principal and rotational axis 11 and comprises, in axial flow series, an air intake 12, a propulsive fan 13, an intermediate pressure compressor 14, a high-pressure compressor 15, combustion equipment 16, a high-pressure turbine 17, and intermediate pressure turbine 18, a low-pressure turbine 19, and an exhaust nozzle 20. A nacelle 21 generally surrounds the engine 10 and defines both the intake 12 and the exhaust nozzle 20.

In operation, air entering the intake 12 is accelerated by the fan 13 to produce two air flows: a first air flow into the intermediate pressure compressor 14 and a second air flow which passes through a bypass duct 22 to provide propulsive thrust. The intermediate pressure compressor 14 compresses the air flow directed into it before delivering that air to the high pressure compressor 15 where further compression takes place.

The compressed air exhausted from the high-pressure compressor 15 is directed into the combustion equipment 16 where it is mixed with fuel and the mixture combusted. The resultant hot combustion products then expand through, and thereby drive the high, intermediate and low-pressure turbines 17, 18, 19 before being exhausted through the nozzle 20 to provide additional propulsive thrust. The high 17, intermediate 18 and low 19 pressure turbines drive respectively the high pressure compressor 15, intermediate pressure compressor 14 and fan 13, each by a suitable interconnecting shaft.

Modelling a gas turbine engine may be a time consuming process and require significant human resources due to the complex structure of the gas turbine engine. For example, a gas turbine engine may be modelled using a traditional computer aided design (CAD) package whereby the model is generated by assembling components from the 'bottom-up'. That is, the modelling process commences with the design of individual product parts, which is then followed by component assembly.

According to various, but not necessarily all, embodiments of the invention there is provided a method of modelling at least a part of a gas turbine engine, the method comprising: preparing a model of at least a part of the gas turbine engine using a data structure including: a first set of data entities representing geometrical shapes of physical features; and a second set of data entities representing geometrical shapes of aerodynamic boundaries, the second set of data entities being used to preserve aerodynamic design intent during preparation of the model.

According to various, but not necessarily all, embodiments of the invention there is provided a method of modelling at least a part of machinery, the method comprising: preparing a model of at least a part of the machinery using a data structure including: a first set of data entities representing geometrical shapes of physical features; and a second set of data entities representing geometrical shapes of aerodynamic boundaries, the second set of data entities being used to preserve aerodynamic design intent during preparation of the model.

At least some data entities of the first set of data entities may be linked to one another.

The first set of data entities may be arranged in a tree structure having parent and child relationships.

The first set of data entities may include: a first subset for at least one physical feature having no functionality; and a second subset for at least one physical feature having functionality.

The geometrical shapes of aerodynamic boundaries may include at least one of: gas turbine engine annulus lines; an aerofoil; an aperture through at least one physical feature; and a clearance between physical features.

One or more physical features may form a component of a gas turbine engine or machinery.

A single assembly of physical features may form a component of a gas turbine engine or machinery.

A plurality of assemblies of physical features may form a component of a gas turbine engine or machinery.

The geometrical shapes of physical features may be defined by geometric parameters.

Preparing a model of the gas turbine engine may include: (i) using the second set of data to define the aerodynamic design intent of the model of the gas turbine engine or machinery; (ii) using the first set of data to provide physical features to the model of the gas turbine engine or machinery to form components; and (iii) modifying the position and/or orientation and/or shape of the provided physical features to preserve the aerodynamic design intent of the model of the gas turbine engine or machinery.

Preparing a model of the gas turbine engine may include: (iv) providing a surface of a physical feature within the model with a pointer to the corresponding physical feature in the first set of data entities.

Preparing a model of the gas turbine engine or the machinery may include: (iv) providing the surface of the physical feature within the model with a tag identifying the position of the surface on the physical feature and/or identifying the function of the physical feature.

The method may further comprise producing a general arrangement drawing of the model of the gas turbine engine or the machinery.

The method may further comprise receiving user input to model a gas turbine engine or machinery; and wherein preparing the model of the gas turbine engine or the machinery may be performed in response to the user input.

According to various, but not necessarily all, embodiments of the invention there is provided a computer program that, when read by a computer, causes performance of the method as described in any of the preceding paragraphs.

According to various, but not necessarily all, embodiments of the invention there is provided a non-transitory computer readable storage medium comprising computer readable instructions that, when read by a computer, causes performance of the method as described in any of the preceding paragraphs.

According to various, but not necessarily all, embodiments of the invention there is provided an apparatus for modelling at least a part of a gas turbine engine, the apparatus comprising: a controller to: prepare a model of at least a part of the gas turbine engine using a data structure including: a first set of data entities representing geometrical shapes of physical features; and a second set of data entities representing geometrical shapes of aerodynamic boundaries, the second set of data entities being used to preserve aerodynamic design intent during preparation of the model.

According to various, but not necessarily all, embodiments of the invention there is provided an apparatus for modelling at least a part of machinery, the apparatus comprising: a controller to: prepare a model of at least a part of the machinery using a data structure including: a first set of data entities representing geometrical shapes of physical features; and a second set of data entities representing geometrical shapes of aerodynamic boundaries, the second set of data entities being used to preserve aerodynamic design intent during preparation of the model.

At least some data entities of the first set of data entities may be linked to one another.

The first set of data entities may be arranged in a tree structure having parent and child relationships.

The first set of data entities may include: a first subset for at least one physical feature having no functionality; and a second subset for at least one physical feature having functionality.

The geometrical shapes of aerodynamic boundaries may include at least one of: gas turbine engine annulus lines; an aerofoil; an aperture through at least one physical feature; and a clearance between physical features.

One or more physical features may form a component of a gas turbine engine or machinery.

A single assembly of physical features may form a component of a gas turbine engine or machinery.

A plurality of assemblies of physical features may form a component of a gas turbine engine or machinery.

The geometrical shapes of physical features may be defined by geometric parameters.

The controller may be arranged to prepare the model of the gas turbine engine by: (i) using the second set of data to define the aerodynamic design intent of the model of the gas turbine engine or the machinery; (ii) using the first set of data to provide physical features to the model to form components of the gas turbine engine or the machinery; and (iii) modifying the position and/or orientation and/or shape of the provided physical features to preserve the aerodynamic design intent of the model of the gas turbine engine or the machinery.

The controller may be arranged to prepare the model of the gas turbine engine or the machinery by: (iv) providing a surface of a physical feature within the model with a pointer to the corresponding physical feature in the first set of data entities.

The controller may be arranged to prepare the model of the gas turbine engine or the machinery by: (iv) providing the surface of the physical feature within the model with a tag identifying the position of the surface on the physical feature and/or identifying the function of the physical feature.

The controller may be arranged to produce a general arrangement drawing of the model of the gas turbine engine or the machinery.

The controller may comprise: at least one processor; at least one memory comprising computer readable instructions; the at least one processor being configured to read the computer readable instructions to cause performance of modelling a gas turbine engine.

The controller may be to receive user input to model a gas turbine engine; and to control preparation of the model of the gas turbine engine in response to the user input.

According to various, but not necessarily all, embodiments of the invention there is provided a method of modelling at least a part of a gas turbine engine, the method comprising: preparing a model of at least a part of the gas turbine engine using a data structure including: a first set of data entities representing geometrical shapes of physical features, the first set of data entities including: a first subset for at least one physical feature having no functionality; and a second subset for at least one physical feature having functionality.

The skilled person will appreciate that except where mutually exclusive, a feature described in relation to any of the above aspects of the invention may be applied mutatis mutandis to any other aspect of the invention.

Embodiments of the invention will now be described by way of example only, with reference to the Figures, in which:
Fig. 1 illustrates a sectional side view of a gas turbine engine;
Fig. 2 illustrates a schematic diagram of apparatus for modelling a gas turbine engine according to various examples;
Fig. 3 illustrates a schematic diagram of a data structure according to various examples;
Fig. 4 illustrates a schematic diagram of data entities, organised in a tree structure, for an intermediate pressure compressor blade disc according to an example;
Fig. 5 illustrates a graphical representation of the data entities illustrated in Fig. 4 according to an example;
Fig. 6 illustrates a schematic diagram of a data entity for a physical feature according to various examples;
Fig. 7 illustrates a flow diagram of a method of modelling a gas turbine engine according to various examples;
Fig. 8 illustrates a flow diagram of a method of preparing a model of a gas turbine engine according to various examples;
Fig. 9 illustrates a cross sectional side view diagram of a geometrical shape of aerodynamic boundaries according to various examples;
Fig. 10 illustrates the cross sectional side view diagram illustrated in Fig. 9 and a plurality of physical features;
Fig. 11 illustrates the cross sectional side view diagram illustrated in Fig. 10 and a further plurality of physical features;
Fig. 12 illustrates a general arrangement drawing produced by the methods described herein; and
Fig. 13 illustrates a flow diagram of another method of modelling a gas turbine engine according to various examples.

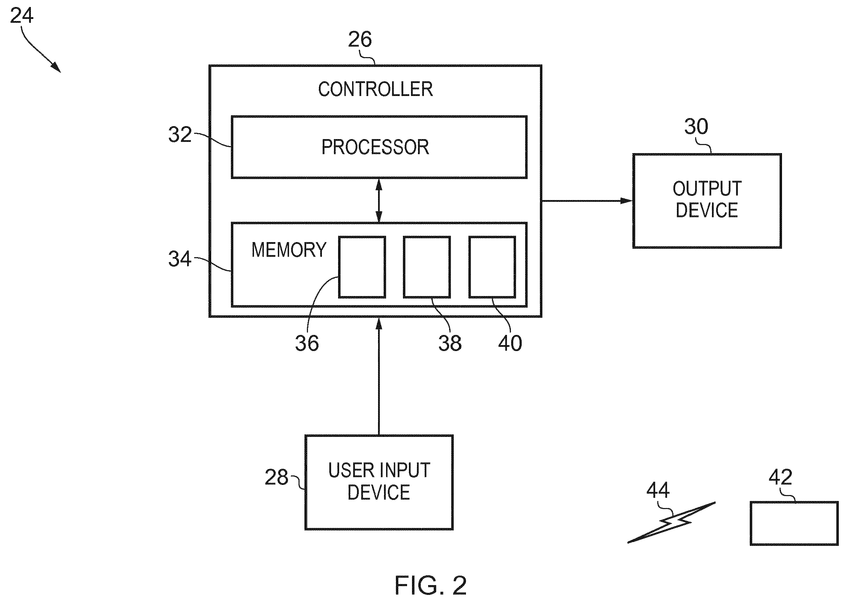

Fig. 2 illustrates an apparatus 24 for modelling at least a part of a gas turbine engine 10. The apparatus 24 includes a controller 26, a user input device 28, and an output device 30. The apparatus 24 may be any computing device and may be located in a single location (for example, the apparatus 24 may be a personal computer (PC) located in a single room) or may be distributed across a plurality of locations (for example, the controller 26 may be located remotely (in another room, building, city, or country) from the user input device 28 and the output device 30).

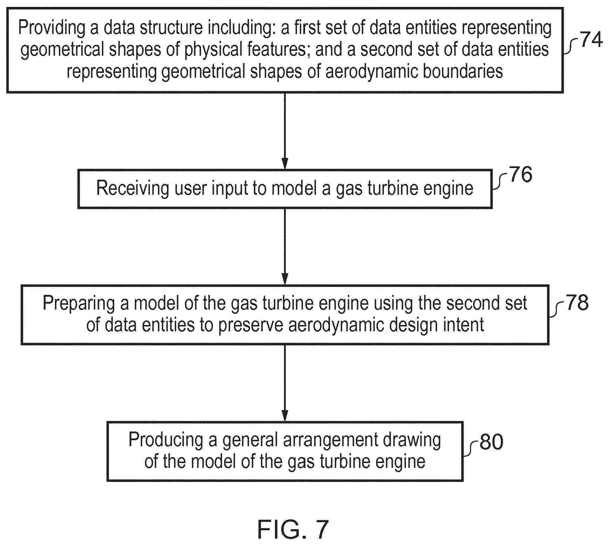

The controller 26 may comprise any suitable circuitry to cause performance of the methods described herein and as illustrated in Figs. 7, 8 and 13. For example, the controller 26 may comprise at least one application specific integrated circuit (ASIC) and/or at least one field programmable gate array (FPGA) to perform the methods. By way of another example, the controller 26 may comprise at least one processor 32 and at least one memory 34. The memory 34 stores a computer program 36 comprising computer readable instructions that, when read by the processor 32, causes performance of the methods described herein, and as illustrated in Figs. 7, 8 and 13. The computer program 36 may be software or firmware, or may be a combination of software and firmware.

The memory 34 stores a data structure 38 that is described in greater detail in the following paragraphs. Generally, the data structure 38 includes a plurality of data entities from which a model of a gas turbine engine may be constructed. Additionally, the memory 34 may store at least one model 40 of a gas turbine engine generated by the apparatus 24 as described in the following paragraphs. In some examples, the memory 34 may not permanently store the model 40 of the gas turbine engine and instead, the model 40 may be built on demand and then stored (at least temporarily) by the memory 34.

The processor 32 may be located at a single location (for example, within a housing or cover of a computer), or may be distributed across a plurality of locations (for example, the processor 32 may be distributed within a plurality of separate housings or covers of different computers, which may be located in the same room, or in different rooms, buildings, cities or countries). The processor 32 may include at least one microprocessor and may comprise a single core processor, or may comprise multiple processor cores (such as a dual core processor, a quad core processor, and so on).

The memory 34 may be located at a single location (for example, within a housing or cover of a computer), or may be distributed across a plurality of locations (for example, the memory 34 may be distributed within a plurality of separate housings or covers of different computers, which may be located in the same room, or in different rooms, buildings, cities or countries). The memory 34 may be any suitable non-transitory computer readable storage medium, data storage device or devices, and may comprise a hard disk and/or solid state memory (such as flash memory). The memory 34 may be permanent non-removable memory, or may be removable memory (such as a universal serial bus (USB) flash drive).

The computer program 36, and/or the data structure 38, and/or the model 40, may be stored on a non-transitory computer readable storage medium 42. The computer program 36, and/or the data structure 38, and/or the model 40, may be transferred from the non-transitory computer readable storage medium 42 to the memory 34. The non-transitory computer readable storage medium 42 may be, for example, a USB flash drive, a compact disc (CD), a digital versatile disc (DVD) or a Blu-ray disc. In some examples, the computer program 42 may be transferred to the memory 34 via a wireless or wired signal 44.

The user input device 28 may include any suitable device or devices for enabling a user to control the apparatus 24. For example, the user input device 28 may include a keyboard, a keypad, a mouse, a touch pad, or a touch screen display. The controller 26 is arranged to receive control signals from the user input device 28.

The output device 30 may include any suitable device or devices for conveying information to a user. For example, the output device 30 may be a display (such as a liquid crystal display, or a light emitting diode display, or an active matrix organic light emitting diode display, or a thin film transistor display, or a cathode ray tube display) and/or a printing device (such as an inkjet printer or a laser printer for example). The controller 26 is arranged to provide a signal to the output device 30 to cause the output device 30 to convey information to the user.

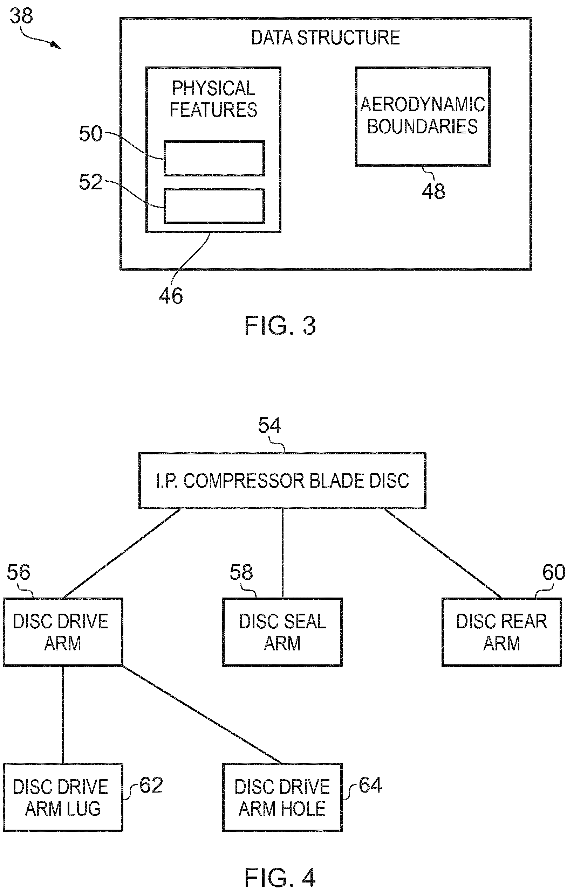

Fig. 3 illustrates a schematic diagram of the data structure 38 including a first set of data entities 46 and a second set of data entities 48. It should be appreciated that the data structure 38 may be coded in any suitable programming language. For example, the data structure 38 may be implemented as a library of object-oriented, hierarchical C++ classes.

The first set of data entities 46 represents geometrical shapes of physical features of a gas turbine engine. As used herein, a 'physical feature' is an assembly of components, a component, or a part of a component, of a gas turbine engine. In other words, a 'physical feature' may not correspond to a single, recognisable component of the gas turbine engine, and each component of a gas turbine engine may be reproduced by assembling one or more physical features.

Data entities in the first set of data entities 46 may be referred to as 'design-objects', which control the geometric representation of the physical features. The data structure 38 comprises a library of multiple data entities, at least some of which may be dedicated to a gas turbine engine application. The data entities 46 may have their own taxonomy and follow an internal hierarchy for acquiring, retaining, hiding and passing on various data.

The first set of data entities 46 may specify the allowable position or positions of physical features within the model of the gas turbine engine. For example, the first set of data entities 46 may specify one or more axial positions for a bearing within a model of the gas turbine engine. Consequently, the first set of data entities 46 may specify starting positions of components or assemblies of components within the model of the gas turbine engine.

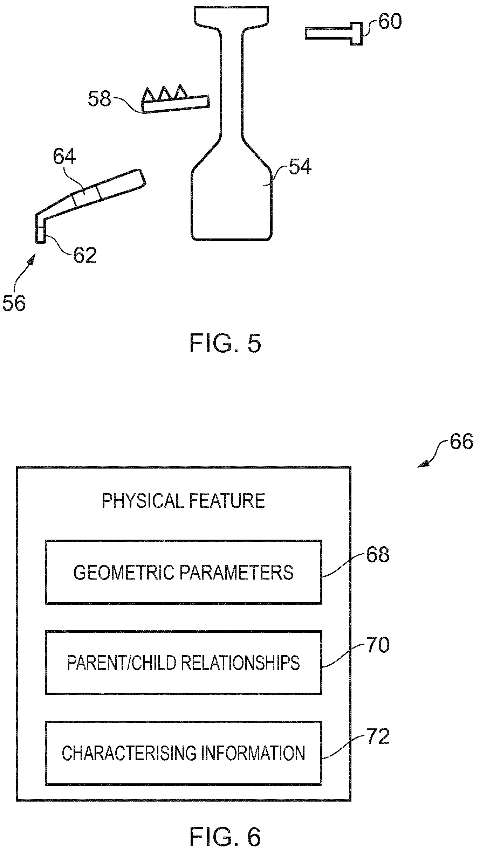

A single assembly of physical features may form a component of a gas turbine engine (as illustrated in Figs. 4 and 5 for an intermediate pressure compressor blade disc). Additionally, a plurality of assemblies of physical features may form a component of a gas turbine engine. For example, a seal may be formed by a rotatable assembly of physical features, and by a stationary assembly of physical features.

In some (but not all) examples, the first set of data entities 46 includes a first subset 50 and a second subset 52 of data entities. The first subset 50 includes at least one data entity for a physical feature having no functionality. That is, the one or more physical features in the first subset 50 may be considered building blocks that do not, in themselves, perform a function in the gas turbine engine. For example, shaft assemblies may be modelled using a plurality of such 'building block' physical features. The second subset 52 includes at least one data entity for a physical feature having functionality. That is, the one or more physical features in the second subset 52 may perform, in themselves, a function in the gas turbine engine. An example of a physical feature having functionality is a labyrinth seal where the parameters of the geometry may be dictated directly by the function of the feature.

As described in greater detail in the following paragraphs with reference to Figs. 4, 5 and 6, the first set of data entities 46 may be arranged in a tree structure having parent and child relationships. In such a tree structure, data entities for physical features located near the root of the assembly tree carry general information and represent high level assemblies, such as spools or modules (or even the whole engine). Such physical features at the root of the tree may also be referred to as 'top level' physical features. Data entities for physical features located near the bottom of the assembly tree represent finer and finer geometric details. Consequently, a child physical feature is an addition to the parent physical feature and the position of the child physical feature may be determined by its position relative to the parent physical feature, and by the position of the parent physical feature. Such physical features near the bottom of the assembly tree may be referred to as 'bottom level' physical features. The assembly tree may be executed by a method that follows a partial sequential or procedural approach.

In other examples, the first set of data entities 46 may not be arranged in a tree structure and instead, at least some of the first set of data entities 46 may be linked to one another. Such assembled data entities may be executed by means of constraint-based declarative statements. For example, one or more of the data entities 46 for a physical feature may include information that allows the physical feature to be positioned (or have its position, orientation, scale or any other geometric property modified according to certain criteria) relative to another physical feature.

It should be appreciated that in the above described examples, the data in the first set of data entities 46 may enable the mechanical design intent of a component or an assembly of components to be generated and preserved. In more detail, where data entities are linked to other data entities or are arranged in a tree structure, the relative positioning of the physical features within the component may be preserved during assembly of the model.

In further examples, the first set of data entities 46 may not be linked to one another or have a tree structure.

The data structure 38 also includes a second set of data entities 48 representing geometrical shapes of aerodynamic boundaries. As used herein, an 'aerodynamic boundary' indicates a boundary for the flow of fluid through the gas turbine engine. An 'aerodynamic boundary' represents the aerodynamic design intent for the gas turbine engine and may be a desired physical boundary (for example, a desired surface of a component positioned within the flow of fluid within the gas turbine engine) or may be a boundary within free space and having no physical surface (that is, an aerodynamic boundary may indicate a desired path within free space for the flow of fluid within the gas turbine engine). The geometrical shapes of aerodynamic boundaries may include one or more of: gas turbine engine annulus lines; an aerofoil; an aperture through at least one physical feature; and a clearance between physical features.

Fig. 4 illustrates a schematic diagram of data entities, illustratively organised in a tree structure, for an intermediate pressure compressor blade disc according to an example. In more detail, the diagram illustrates an intermediate pressure (IP) compressor blade disc data entity 54, a disc drive arm data entity 56, a disc seal arm data entity 58, a disc rear arm data entity 60, a disc drive arm lug data entity 62, and a disc drive arm hole data entity 64. It should be appreciated that the data entities 54, 56, 58, 60, 62, 64 are a subset of the data structure 38 for the gas turbine engine.

The tree structure is arranged so that the IP compressor blade disc data entity 54 is the root of the tree structure and is the parent physical feature to the disc drive arm data entity 56, the disc seal arm data entity 58, and the disc rear arm data entity 60. The disc drive arm data entity 56 is the parent physical feature to the disc drive arm lug data entity 62 and to the disc drive arm hole data entity 64.

Fig. 5 illustrates a graphical representation of the intermediate pressure (IP) compressor blade disc data entity 54, the disc drive arm data entity 56, the disc seal arm data entity 58, the disc rear arm data entity 60, the disc drive arm lug data entity 62, and the disc drive arm hole data entity 64.

Fig. 6 illustrates a schematic diagram of a data entity 66 for a physical feature according to various examples. The data entity 66 includes geometric parameters 68, parent/child relationship data 70, and characterizing information 72.

The geometric parameters 68 define the shape of the physical feature. For example, where the physical feature is a disc, the geometric parameters 68 define the radius and depth of the disc. The geometric parameters 68 enable the controller 26 to present the physical feature via the output device 30 and graphically represent the physical feature. Where the physical feature is an aperture or a cavity in a parent physical feature, the geometric parameters 68 may define the aperture or cavity as the removal of material from the parent physical feature.

When a data entity 66 is initiated and geometric parameters are defined, the controller 26 may advantageously perform intra-data structure validations. For example, the controller 26 may validate the dimensions of the geometric parameters, and for some data entities, the controller 26 may also check the type of parent data entity and the self-attachment location.

The parent/child relationship data 70 identifies the parent physical feature and/or the child physical feature(s) for that particular physical feature. The parent/child relationship data 70 may also define the intended positioning between the physical feature and the parent physical feature and/or the child physical feature. The final position of a physical feature may be altered by the user or by the apparatus 24 according to certain criteria, which are described in greater detail in the following paragraphs.

The characterising information 72 includes data that characterises the physical feature and/or the data entity 66 for the physical feature. For example, the characterising information 72 may include a bill of materials for the physical feature, manufacturing instructions, modification history for the data entity 66, and/or the designer's notes.

The operation of the apparatus 24 in modelling at least a part of a gas turbine engine is described in the following paragraphs with reference to Fig. 7.

At block 74, the method includes providing the data structure 38 including the first set of data entities 46 representing geometrical shapes of physical features, and the second set of data entities 48 representing geometrical shapes of aerodynamic boundaries. For example, the data structure 38 (or a part of the data structure 38) may be provided by a user of the apparatus 24 who uses the apparatus 24 (or another computing device) to enter data for new data entities (either in the first or second set of data entities 46, 48) to generate the data structure 38. By way of another example, the data structure 38 (or a part of the data structure 38) may be provided by the controller 26 loading or accessing the data structure 38 from the memory 34.

At block 76, the method includes receiving user input to model a gas turbine engine. For example, the controller 26 may receive a control signal from the user input device 28 that directly initiates modelling of a gas turbine engine (for example, the user 'presses' a button displayed in a graphical user interface that commences modelling of the gas turbine engine). By way of another example, the controller 26 may receive a control signal from the user input device 28 that indirectly initiates modelling of a gas turbine engine (for example, the user loads the modelling software that then automatically models a gas turbine engine).

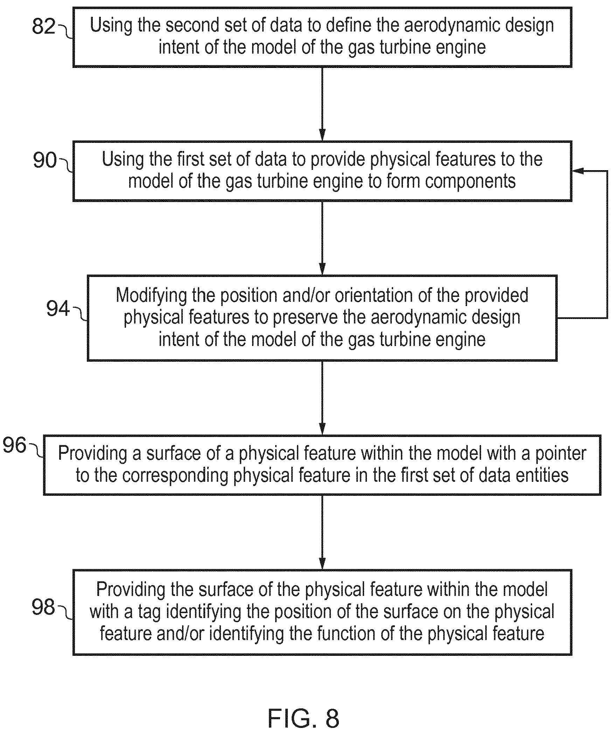

At block 78, the method includes preparing a model of the gas turbine engine using the second set of data entities 48 to preserve the aerodynamic design intent. An example of the methodology within block 78 is illustrated in Fig. 8 and described in the following paragraphs. Generally, in block 78 the method may include positioning physical features in the model so that they are not located within the aerodynamic boundaries defined by the second set of data entities 48 (and therefore do not restrict the desired flow of fluid through the gas turbine engine). Consequently, the aerodynamic design intent may be preserved by re-positioning physical features so that they do not occupy any space within the aerodynamic boundaries defined by the second set of data entities. In some examples, the aerodynamic design intent may be preserved by re-positioning physical features in the model so that they occupy less space within (but are still positioned within, if only to a minimal extent) within the aerodynamic boundaries defined by the second set of data entities

Upon completion of block 78, the controller 26 may store the model 40 in the memory 34. The model 40 may then be used to simulate the operation of the gas turbine engine. In some examples, the model 40 may be a model of a part of a gas turbine engine (for example, a compressor module of a gas turbine engine). In other examples, the model 40 may be a model of the whole of the gas turbine engine (that is, the model 40 is a model of an in-service gas turbine engine mounted on a wing of an aircraft).

At block 80, the method includes producing a general arrangement drawing of the model of the gas turbine engine prepared in block 78. For example, the controller 26 may control a display of the output device 30 to display a general arrangement drawing of the prepared model. By way of another example, the controller 26 may control a printer of the output device 30 to print a general arrangement drawing on a printing medium (such as paper).

Fig. 8 illustrates a flow diagram of a method of preparing a model of a gas turbine engine according to various examples. The blocks illustrated in Fig. 8 may form at least a part of block 78 illustrated in Fig. 7.

At block 82, the method includes using the second set of data 48 to define the aerodynamic design intent of the model of the gas turbine engine. In some examples, a user may directly select one or more geometrical shapes from the second set of data 48 via a graphical user interface. In other examples, a user may provide a desired set of parameters (for example, a desired size for the gas turbine engine) to the controller 26 via the user input device 28, and the controller 26 may then select one or more geometrical shapes from the second set of data 48 that most closely match the desired set of parameters.

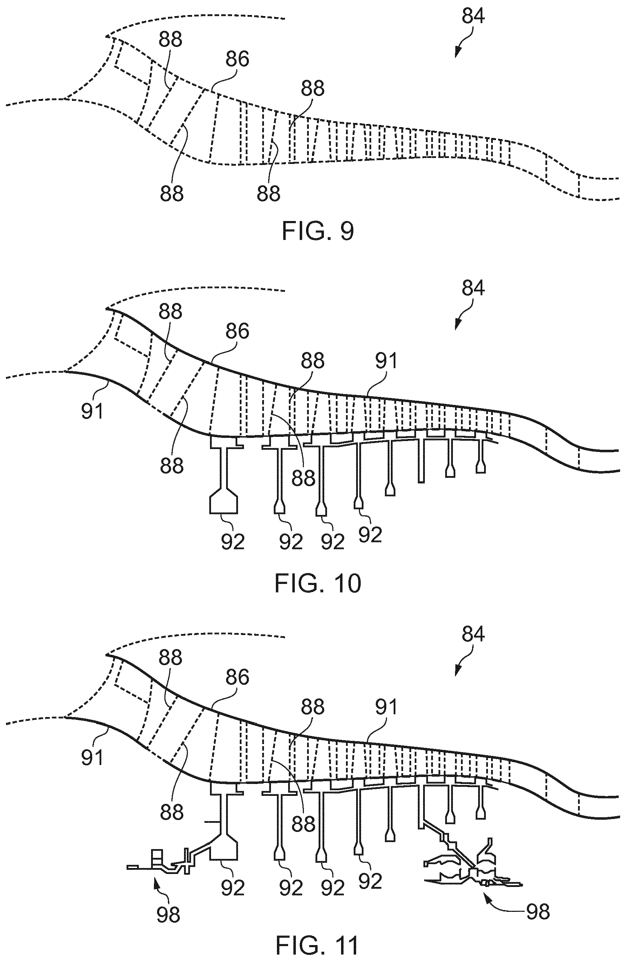

By way of an example, Fig. 9 illustrates a cross sectional side view diagram of a model including the geometrical shape 84 of the aerodynamic boundaries of a compressor of a gas turbine engine. The geometrical shape 84 comprises a plurality of dotted lines 86 that represent the aerodynamic boundaries of the compressor main fluid flow passage. The geometrical shape 84 also comprises a plurality of dotted lines 88 that represent the aerodynamic boundaries of leading and trailing edges of compressor blades.

At block 90, the method includes using the first set of data to provide physical features to the model of the gas turbine engine to form components. The controller 26 may provide physical features to the model in order of their proximity to the dotted lines 86, 88 of the geometrical shape 84. For example (and with reference to Fig. 10), the controller 26 may provide the geometrical shape 84 of the compressor with physical features from the first set of data entities 46 to form a plurality of end walls 91 and compressor discs 92 within the model. The physical features provided to the model may include physical features (not having functionality) from the first subset 50 and physical features (having functionality) from the second subset 52.

At block 94, the method includes modifying the position and/or orientation and/or shape of at least one provided physical feature to preserve the aerodynamic design intent of the model of the gas turbine engine. For example, the controller 26 may determine that a compressor disc extends over one or more of the dotted lines 86, 88 within the model, and may then re-position the compressor disc to not extend over the dotted line (or dotted lines) and thereby preserve the aerodynamic design intent of the compressor. In some examples, the controller 26 may determine that a physical feature extends over one or more dotted lines by comparing the locations of the perimeter of the physical feature in a coordinate system with the locations of the one or more dotted lines in the coordinate system.

Where the physical features are organised within a tree structure in the data structure 38, parent and child physical features may also be re-positioned by the controller 26 when a physical feature is moved in order to preserve the aerodynamic design intent. In particular, once the controller 26 has determined that a physical feature is to be moved, the controller 26 uses the parent/child relationship data 70 to determine whether a parent or child feature should also be moved a corresponding distance to preserve the geometrical shape of the component within the model.

For example, where the controller 26 has determined that an intermediate pressure compressor blade disc 54 is to be moved within the model, the controller 26 may use the parent/child relationship data 70 of the disc data entity 54 to determine that the disc drive arm 56, the disc seal arm 58, the disc rear arm 60 are also to be moved. Since the disc drive arm 56 has the child physical features: disc drive arm lug 62; and the disc drive arm hole 64, the controller 26 may also re-position the disc arm lug 62 and the disc drive arm hole 64 within the model using the parent/child relationship data 70 of the disc drive arm 56 to preserve the geometrical shape of the compressor disc.

Where the controller 26 determines that no further physical features are to be provided to the model, the method moves to block 96.

Where the controller 26 determines that further physical features are to be provided to the model (for example, child features of physical features already within the model), the method returns to block 90. For example, as illustrated in Fig. 11, the controller 26 may provide additional physical features 98 to the model after block 94 has been performed.

At block 96, the method may include providing a surface of a physical feature within the model with a pointer to the corresponding physical feature data entity in the first set of data entities 46. For example, the surface of the compressor disc 92 in the model may be provided with a pointer to the IP compressor blade disc data entity 54. The pointer may be an address that identifies the location of the corresponding data entity within the data structure 38.

An advantage of block 96 is that it may allow surfaces to be identified automatically when an analysis needs to be performed for that component. As an example, one may consider the case of a flow analysis on a cavity in the internal volume of the core. Such an analysis may require data, such as roughness. Then, if the analysis program has access to the model built according to the present disclosure, the analysis program may be able to interrogate the surface and retrieve the bill of materials and manufacturing instructions for the corresponding component, and hence the roughness.

At block 98, the method may include providing the surface of the physical feature within the model with a tag identifying the position of the surface on the physical feature and/or identifying the function of the physical feature. For example, the controller 26 may provide at least one surface of the compressor disc 92 with a tag that identifies the position of that surface on the disc and/or identifies that the function of the compressor disc is to rotate.

An advantage of block 98 is that it may enable the identification of surfaces of a physical feature. For the purpose of programs accessing the database, surfaces having such a tag contain a link to the physical feature data entity. The additional tag also allows a program to identify "which" surface on that physical feature has been accessed.

Once the model has been completed and stored in the memory 34, the method may move to block 80 and the apparatus 24 may produce a general arrangement drawing of the model of the whole of the gas turbine engine. In some examples, the apparatus 24 may produce a general arrangement drawing of a model of only a part of the gas turbine engine.

The method may additionally validate inter-data entity relationships and geometric assembly relationships such as attachment pre-conditions, interaction and data transfer and geometry interference. The method may then highlight incorrect and/or impermissible types of attachments and geometric interferences.

It should be appreciated that at least some of the blocks 74, 76, 78, 80, 82, 90, 94, 96, 98 may be controlled or initiated by the controller 26. Additionally or alternatively, at least some of the blocks 74, 76, 78, 80, 82, 90, 94, 96, 98 may be controlled or initiated by a human operator of the apparatus 24. Additionally or alternatively, at least some of the blocks 74, 76, 78, 80, 82, 90, 94, 96, 98 may be controlled or initiated by another program which has access to a representation of gas turbine geometry.

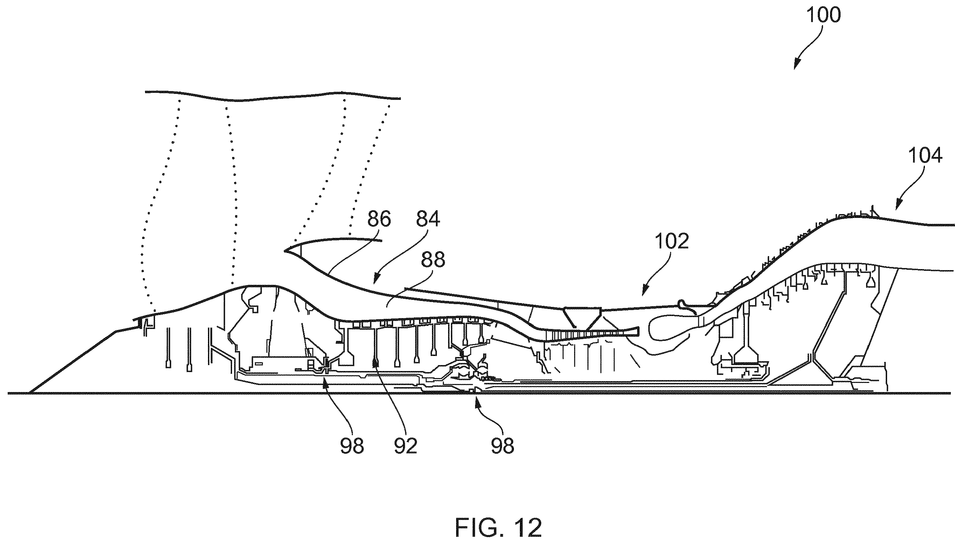

Fig. 12 illustrates a general arrangement drawing 100 produced by the method described above. The general arrangement drawing includes the compressor section illustrated in Figs. 9 to 11, and also includes a combustor 102 and a turbine section 104.

The apparatus 24 and above described method may be advantageous in that the use of the second set of data entities enables a model of a gas turbine engine to be prepared that preserves the aerodynamic design intent of the designer of the model. This may enable the gas turbine engine to be modelled from the 'top down'. In other words, the model may be prepared by starting with a functional design (that is, the geometrical shapes of the aerodynamic boundaries), followed by a coarser to fine design process (that is, primary or core physical features at the root of the tree structure, followed by successive child physical features that fill in further geometric features).

Additionally, the apparatus 24 and the above described method may be advantageous in that since the data structure 38 may have a tree structure (or since the data entities in the data structure 38 are linked as described above), changes made to the position and/or orientation of a parent physical feature may carry through to successive child physical features. This may reduce the human resources required for preparing the model of the gas turbine engine.

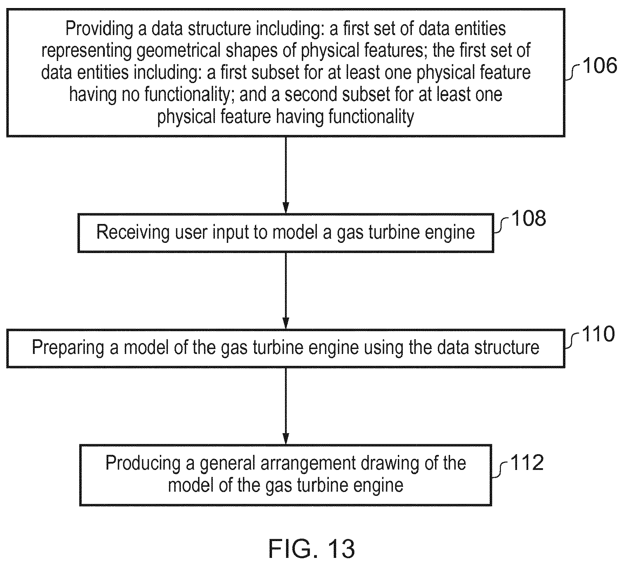

Fig. 13 illustrates a flow diagram of another method of modelling a gas turbine engine according to various examples. In these examples, the data structure 38 includes the first and second subset 50, 52 of first data entities 46, but may or may not include the second set of data entities 48.

At block 106, the method includes providing a data structure including a first set of data entities representing geometrical shapes of physical features. The first set of data entities comprises: a first subset for at least one physical feature having no functionality; and a second subset for at least one physical feature having functionality. For example, the data structure 38 (or a part of the data structure 38) may be provided by a user of the apparatus 24 who uses the apparatus 24 (or another computing device) to enter data for new data entities in the data structure 38. By way of another example, the data structure 38 (or a part of the data structure 38) may be provided by the controller 26 loading or accessing the data structure 38 from the memory 34.

At block 108, the method includes receiving user input to model a gas turbine engine. For example, the controller 26 may receive a control signal from the user input device 28 that directly initiates modelling of a gas turbine engine (for example, the user 'presses' a button displayed in a graphical user interface that commences modelling of the gas turbine engine). By way of another example, the controller 26 may receive a control signal from the user input device 28 that indirectly initiates modelling of a gas turbine engine (for example, the user loads the modelling software that then automatically models a gas turbine engine).

At block 110, the method includes preparing a model of the gas turbine engine using the first set of data entities 46 (and optionally the second set of data entities 48). In more detail, the model of the gas turbine engine may be prepared using physical features having no functionality (that is, physical features that are building blocks (or primary or core physical features) that do not perform a function in themselves) and using physical features that have functionality (that is, the physical features in the first and second subsets 50, 52 of the first set of data entities 46).

At block 112, the method includes producing a general arrangement drawing of the model of the gas turbine engine prepared in block 110. For example, the controller 26 may control a display of the output device 30 to display a general arrangement drawing of the prepared model. By way of another example, the controller 26 may control a printer of the output device 30 to print a general arrangement drawing on a printing medium (such as paper).

It should be appreciated that at least some of the blocks 106, 108, 110, 112 may be controlled or initiated by the controller 26. Additionally or alternatively, at least some of the blocks 106, 108, 110, 112 may be controlled or initiated by a human operator of the apparatus 24.

It will be understood that the invention is not limited to the embodiments above-described and various modifications and improvements can be made without departing from the various concepts described herein. For example, the above described methods may be used to model machinery other than gas turbine engines, and may be used to model rotating electrical machinery for example. Furthermore, the above described methods may be used to model a gas turbine engine having a different (architecture) to the one mentioned in the preceding paragraphs. For example, the above described methods may be used to model a two shaft gas turbine engine.

Except where mutually exclusive, any of the features may be employed separately or in combination with any other features and the invention extends to and includes all combinations and sub-combinations of one or more features described herein in any form.

## Claims

1. A method of modelling at least a part of a gas turbine engine, the method comprising:
preparing a model of at least a part of the gas turbine engine using a data structure including: a first set of data entities representing geometrical shapes of physical features; and a second set of data entities representing geometrical shapes of aerodynamic boundaries, the second set of data entities being used to preserve aerodynamic design intent during preparation of the model.

2. A method as claimed in claim 1, wherein at least some data entities of the first set of data entities are linked to one another.

3. A method as claimed in claim 1 or 2, wherein the first set of data entities are arranged in a tree structure having parent and child relationships.

4. A method as claimed in any of the preceding claims, wherein the first set of data entities include: a first subset for at least one physical feature having no functionality; and a second subset for at least one physical feature having functionality.

5. A method as claimed in any of the preceding claims, wherein the geometrical shapes of aerodynamic boundaries include at least one of: gas turbine engine annulus lines; an aerofoil; an aperture through at least one physical feature; and a clearance between physical features.

6. A method as claimed in any of the preceding claims, wherein one or more physical features form a component of a gas turbine engine, or wherein a single assembly of physical features forms a component of a gas turbine engine, or wherein a plurality of assemblies of physical features forms a component of a gas turbine engine.

7. A method as claimed in any of the preceding claims, wherein the geometrical shapes of physical features are defined by geometric parameters.

8. A method as claimed in any of the preceding claims, wherein preparing a model of the gas turbine engine includes: (i) using the second set of data to define the aerodynamic design intent of the model of the gas turbine engine; (ii) using the first set of data to provide physical features to the model of the gas turbine engine to form components; and (iii) modifying the position and/or orientation and/or shape of the provided physical features to preserve the aerodynamic design intent of the model of the gas turbine engine.

9. A method as claimed in any of the preceding claims, wherein preparing a model of the gas turbine engine includes: (iv) providing a surface of a physical feature within the model with a pointer to the corresponding physical feature in the first set of data entities.

10. A method as claimed in any of the preceding claims, wherein preparing a model of the gas turbine engine includes: (iv) providing the surface of the physical feature within the model with a tag identifying the position of the surface on the physical feature and/or identifying the function of the physical feature.

11. A method as claimed in any of the preceding claims, further comprising producing a general arrangement drawing of the model of the gas turbine engine.

12. A method as claimed in any of the preceding claims, further comprising receiving user input to model a gas turbine engine; and wherein preparing the model of the gas turbine engine is performed in response to the user input.

13. A computer program that, when read by a computer, causes performance of the method as claimed in any of the preceding claims.

14. A non-transitory computer readable storage medium comprising computer readable instructions that, when read by a computer, causes performance of the method as claimed in any of claims 1 to 12.

15. An apparatus for modelling at least a part of a gas turbine engine, the apparatus comprising: a controller to cause performance of the method as claimed in any of claims 1 to 12.
